# EUROPEAN PATENT APPLICATION

(11) **EP 4 672 493 A1**
(43) Date of publication of application: **31.12.2025**
(21) Application number: 24760445.7
(22) Date of filing: 22.02.2024
(51) Int. Cl.: H01P 5/02, H01P 1/04, H05K 1/14

(54) **HIGH-FREQUENCY CONNECTION LINE**

(30) Priority: 24.02.2023 JP 2023027371
(71) Applicant: NTT, Inc., Tokyo 100-8116 (JP); NTT Innovative Devices Corporation, Yokohama-shi, Kanagawa 221-0031 (JP)
(72) Inventor: OZAKI Josuke, Musashino-shi, Tokyo 180-8585 (JP); NUNOYA Nobuhiro, Musashino-shi, Tokyo 180-8585 (JP); TANOBE Hiromasa, Kawasaki-shi, Kanagawa 212-8510 (JP); FUKUYAMA Hiroyuki, Kawasaki-shi, Kanagawa 212-8510 (JP)
(74) Representative: TBK
(86) International application number: PCT/JP2024/006588
(87) International publication number: WO 2024/177147

(57) **Abstract**

A radio frequency connection line in an embodiment includes a first main line including a first signal line and a first earthing ground of a first radio frequency line and a second main line including a second signal line and a second earthing ground of a second radio frequency line, the first signal line and the second signal line are connected via joining of a first signal pad and a third signal pad, the first earthing ground and the second earthing ground are connected via joining of a first ground pad and a third ground pad, a gap between the third signal pad and an earthing ground layer is set smaller than a quarter of a guide wavelength, and an interval between the second signal pad and the second ground pad is set narrower than an interval between the second signal line and the second earthing ground.

## Description

### Technical Field

The present disclosure relates to a radio frequency connection line and, more specifically, to a radio frequency connection line in which radio frequency lines, the structures of end potions of which in a connection region are different from one another, are connected, the radio frequency connection line being capable of matching not only characteristic impedance in the connection region of the end portions of the radio frequency lines but also characteristic impedance in the entire radio frequency lines including portions other than the connection region with desired characteristic impedance.

### Background Art

In radio frequency lines having predetermined characteristic impedance, when line ends of separate radio frequency lines are electrically connected to face one another, a reduction in a return loss in a connection region is generally assessed as an important issue.

In particular, in optical modules such as a TOSA (Transmit Optical Sub-Assembly), an ROSA (Receiver Optical Sub-Assembly), a BOSA (Bi-directional Optical Sub Assembly), a CDM (Coherent Driver Modulators), and an ICR (Intradyne Coherent Receiver) frequently used in an optical communication system, in general, different substrates joining for joining a radio frequency line on a rigid substrate and a radio frequency line on a flexible substrate having flexibility is performed. In an optical communication system of 200 GBd, which is a higher baud rate, used in high-speed wideband optical communication, suppression of a return loss of a radio frequency signal propagating in a region of the different substrates joining has been an urgent issue that should be solved.

For example, a metal pad configuring an end portion of the radio frequency line included in the rigid substrate is located on the surface of the rigid substrate. On the other hand, a metal pad introduced into the flexible substrate to be joined to the metal pad is located on the lower surface of the flexible substrate. However, in general, a radio frequency signal line is located on the upper surface of the flexible substrate. For this reason, in the region of the different substrates joining, it is necessary to pull out the metal pad on the lower surface of the flexible substrate to the radio frequency signal line on the upper surface. As long as such a radio frequency connection line is adopted, it is considered relatively difficult to obtain matching of characteristic impedance for the purpose of the return loss reduction. Nevertheless, in the optical module of the related art, a radio frequency connection line in which a change in characteristic impedance after joining is reduced by performing optimization of the shape of a radio frequency line for each of a rigid substrate and a flexible substrate has been widely adopted.

In the radio frequency line formed on the flexible substrate adopted in the optical module of the related art, in general, a structure of a microstrip line including a signal line on the upper surface of the flexible substrate and including a grounding conductor on the lower surface is adopted (see, for example, Patent Literatures 1 and 2). Since the microstrip line is particularly relatively simple structure among numerous types of radio frequency lines, a main reason for the adoption is that high manufacturing accuracy is easily obtained with relatively low expenses (see Patent Literature 2).

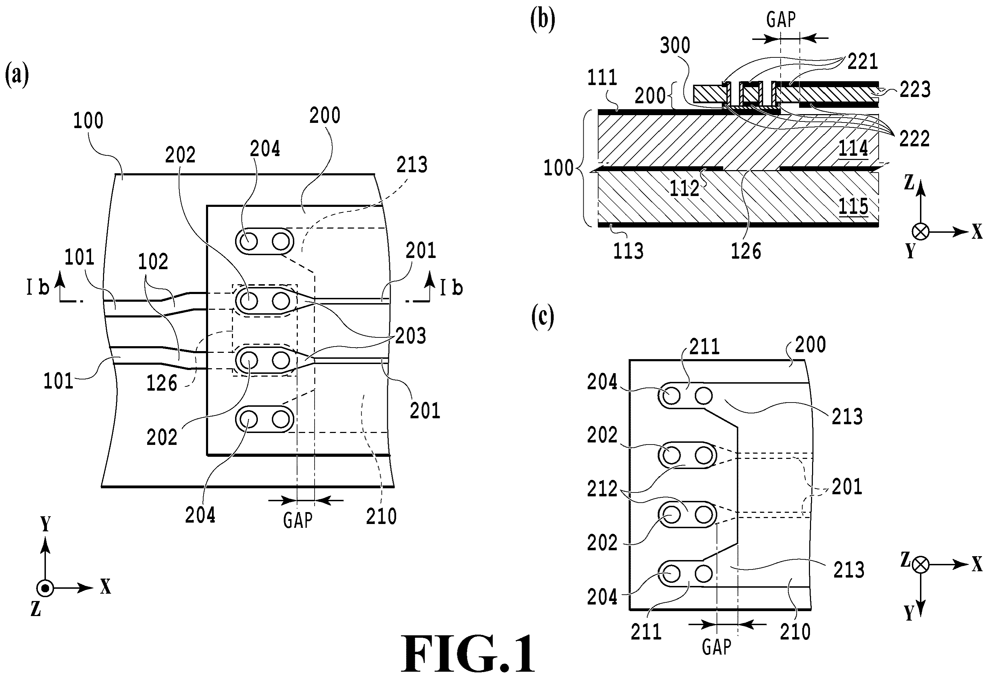

A structure of a connection region in joining an end of a radio frequency line on a rigid substrate (100) and an end of a radio frequency line on a flexible substrate (200) to face each other is explained with reference to Figure 1. Figure 1(a) is a top view of the connection region, Figure 1(b) is an Ib-Ib sectional view of the connection region, and Figure 1(c) is a bottom view of the flexible substrate (200).

The rigid substrate (100) includes a differential microstrip line including two signal lines (101) pattern-formed using a first wiring layer (111) of the rigid substrate on the upper surface thereof. At this time, a ground defining earthing ground potential of the differential microstrip line of the rigid substrate (100) is a second wiring layer (112) and a third wiring layer (113) located in a lower layer of the rigid substrate (100). Earthing ground potentials of the first wiring layer (111), the second wiring layer (112), and the third wiring layer (113) are made common by a ground VIA (not illustrated) penetrating the rigid substrate (100). A first insulating layer (114) and a second insulating layer (115) are formed among the wiring layers.

On the other hand, the flexible substrate (200) includes a differential microstrip line including two signal lines (201) pattern-formed using a first wiring layer (221) of the flexible substrate (200) on the upper surface thereof. In a second wiring layer (222) located on the rear surface of the flexible substrate (200), a signal pad (202) and a ground pad (211) to be joined to the rigid substrate (100) are pattern-formed and disposed at predetermined positions. Since an end portion of the first wiring layer (221) of the flexible substrate (200) and a signal pad (212) and the ground pad (211) of the second wiring layer (222) provided anew are respectively independently formed on the upper surface and the lower surface of a first insulating layer (223) of the flexible substrate (200), the end portion and the signal pad (212) and the ground pad (211) are not electrically connected to each other in this state. Thus, the flexible substrate (200) includes, at predetermined positions, a signal VIA (202) and a ground VIA (204) for penetrating the first insulating layer (223) of the flexible substrate (200) and making the first insulating layer (223) conductive. At this time, in order to suppress a marked drop of characteristic impedance in a joining part, a ground opening (126) is selectively introduced into the second wiring layer 112 configuring the rigid substrate (100).

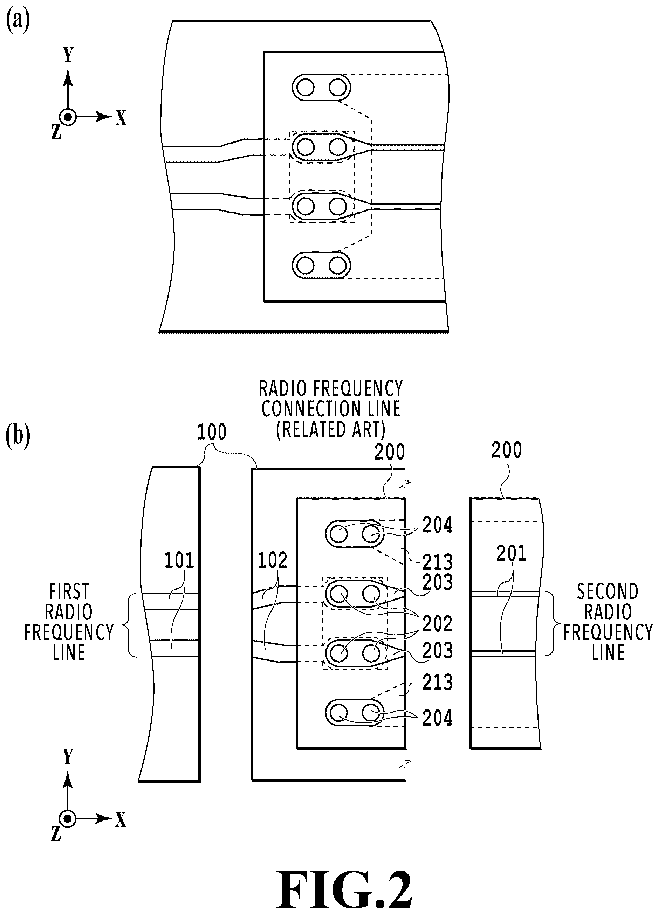

Figure 2 is a diagram for facilitating a divided discussion for each of functions of the structure of the connection region of the related art illustrated in Figure 1. Figure 2(a) is a top view of the connection region of the radio frequency connection line of the related art and Figure 2(b) is a diagram virtually divided for each of the functions on the paper surface. A first radio frequency line formed on the upper surface of the rigid substrate (100) is present on the left side of Figure 2(b). A second radio frequency line formed on the upper surface of the flexible substrate

(200) is present on the right side of Figure 2(b). It is seen that the first radio frequency line and the second radio frequency line respectively have different characteristics in terms of structure. For example, line widths and pitches of the lines are clearly different. In this way, in general, when substrates in which materials forming insulating layers and thicknesses of the insulating layers are different are used, even if characteristic impedances are the same, shapes and arrangements of obtained metal patterns, which are shapes of radio frequency lines, do not always match. Thus, when one ends and the other ends of two radio frequency lines are joined to face each other, a radio frequency connection line having a special structure is necessary. A structure located in the center of Figure 2(b) corresponds to the radio frequency connection line.

In the flexible substrate (200) in the radio frequency connection line in the center of Figure 2(b), a signal line taper section (203) is introduced into the first wiring layer (221) on the upper surface and a ground layer taper section (213) is introduced into the second wiring layer (222) on the lower surface. On the other hand, in the rigid substrate (100) in the radio frequency connection line, a signal line pitch conversion section (102) is introduced into the first wiring layer 111 on the upper surface. Further, immediately below a region where the radio frequency connection line of the flexible substrate (200) and the radio frequency connection line of the rigid substrate (100) are joined to each other by solder (300) or the like, a ground opening (126) is selectively introduced in the second wiring layer 112 of the rigid substrate (100).

Incidentally, unlike the optical communication of the related art to which Patent Literatures 1 and 2 are adopted, in an optical module used in optical communication at a high baud rate of 200 GBd, design of a radio frequency connection line implemented inside the optical module is greatly transformed from lumped constant treatment to distributed constant treatment. In particular, a part where such treatment is requested in Figure 1 is the signal line taper section (203). In order to cause the signal line taper section (203) to function as the radio frequency signal line, an earthing ground serving as a reference is necessary in the second wiring layer (222) immediately below the flexible substrate (200) across the first insulating layer (223). However, as it is understood from the bottom view of the flexible substrate (200) illustrated in Figure 1(c), in order to prevent short-circuit with the signal pad (212) included in the second wiring layer (222), a predetermined gap is provided between the ground layer (210), which provides reference potential, and the signal pad (212).

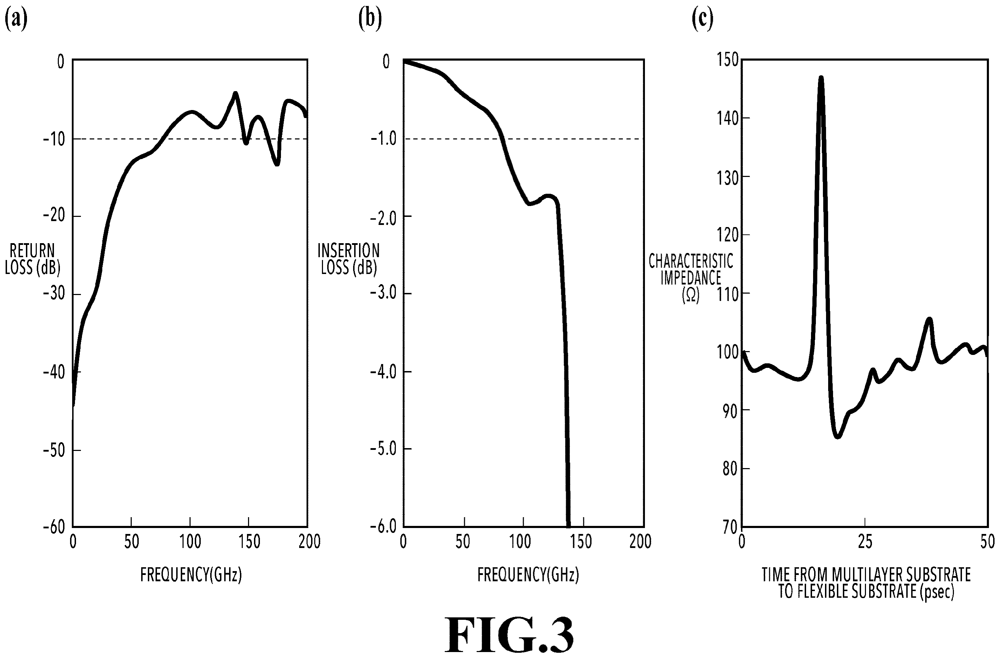

When the size (the length in an X-axis direction) of the gap between the ground layer (210) and the signal pad (212) is sufficiently smaller than (1/16) to (1/4) of a guide wavelength (a wavelength along the signal line (201)) of a radio frequency signal propagating in the signal line taper section (203) of the second wiring layer (221), the gap is treated as a lumped constant. If the gap can be electrically corrected in the flexible substrate (200), it is relatively less likely that reflection of the radio frequency signal occurs in the signal line taper section (203). However, a frequency of a radio frequency signal in use exceeds 100 GHz in the optical communication at a high baud rate of 200 GBd. Accordingly, since length equivalent to (1/16) to (1/4) of the guide wavelength exceeding 100 GHz is smaller than the size of the gap, it is difficult to electrically treat the gap part as the lumped constant. Strong inductivity is developed in the gap, that is, in the signal line taper section (203). Figure 3 illustrates an S parameter and characteristic impedance of the radio frequency connection line of the related art at the time when the size of the gap is set to 200 µm. Figurer 3(a) illustrates a simulation waveform of a graph trace of a return loss of the S parameter, Figure 3(b) illustrates a simulation waveform of a graph trace of a insertion loss of the S parameter, and Figure 3(c) illustrates a simulation waveform of a graph trace of characteristic impedance due to TDR (time domain reflectometry). It is clear that a high-impedance characteristic due to the development of the inductivity is indicated. Thus, it has been difficult to apply the radio frequency connection line by the related art illustrated in Figure 1 and Figure 2 to a radio frequency signal used in the optical communication at 200 GBd.

### Citation List

### Patent Literature

Patent Literature 1: Japanese Patent Laid-Open No. 2007-123741
Patent Literature 2: Japanese Patent Laid-Open No. 2010-200234

### Summary of the Invention

As explained above, in the radio frequency connection line, a part where characteristic impedance does not match is caused by a rise in the characteristic impedance due to the development of the inductivity, whereby deterioration in signal quality of a radio frequency signal occurs.

The present disclosure has been devised in view of the problems described above, and an object of the present disclosure is to provide a radio frequency connection line in which characteristic impedance is matched when end portions of radio frequency lines formed on separate substrates are connected at the respective substrate end portions in a form in which the end portions are set in contact with each other.

An embodiment of the present invention is a radio frequency connection line in which a first radio frequency line formed on a first substrate having insulation and a second radio frequency line formed on a second substrate having insulation different from the first substrate are electrically connected.

The first radio frequency line in the radio frequency connection line in the embodiment includes a first main line having conductivity formed on an upper surface of the first substrate, the first main line including a first signal line, a first signal pad electrically connected to an end portion of the first signal line formed on the upper surface of the first substrate, and a first ground pad formed on the upper surface of the first substrate.

The second radio frequency line in the radio frequency connection line in the embodiment includes a second main line having conductivity formed on an upper surface of the second substrate, the second main line including a second signal line and a second earthing ground formed on the upper surface of the second substrate, a second signal pad electrically connected to an end portion of the second signal line formed on the upper surface of the second substrate, a second ground pad electrically connected to an end portion of the second earthing ground formed on the upper surface of the second substrate, a third signal pad formed at a position immediately below the second signal pad on a lower surface of the second substrate, and an earthing ground layer formed on the lower surface of the second substrate in a form of surrounding the third signal pad, the earthing ground layer including a third ground pad formed at a position immediately below the second ground pad on the lower surface of the second substrate.

The first signal pad and the third signal pad are joined to face each other, and the first ground pad and the third ground pad are joined to face each other.

In the radio frequency connection line in the embodiment, a gap between the third signal pad and the earthing ground layer in a longitudinal direction of the second radio frequency line is smaller than a quarter of a guide wavelength, width of the second signal pad in a direction perpendicular to the longitudinal direction of the second radio frequency line is larger than width of the second signal line in the direction perpendicular to the longitudinal direction of the second radio frequency line, and an interval between the second signal pad and the second ground pad is narrower than an interval between the second signal line and the second earthing ground.

According to the embodiment of the present invention, it is possible to provide a radio frequency connection line in which characteristic impedance is matched.

### Brief Description of Drawings

[Figure 1] Figure 1 is a diagram for explaining a structure of a connection region of a radio frequency connection line of the related art, Figure 1(a) is a top view of the connection region, Figure 1(b) is a sectional view in an Ib-Ib line of Figure 1(a), and Figure 1(c) is a bottom view of a flexible substrate (200).
[Figure 2] Figure 2(a) is a top view of the connection region of the radio frequency connection line of the related art and Figure 2(b) is a diagram divided for each of functions.
[Figure 3] Figure 3 is a diagram illustrating an S parameter and characteristic impedance of the radio frequency connection line of the related art, Figure 3(a) is a graph trace of a return loss, Figure 3(b) is a graph trace of a insertion loss, and Figure 3(c) is a graph trace of characteristic impedance due to TDR.

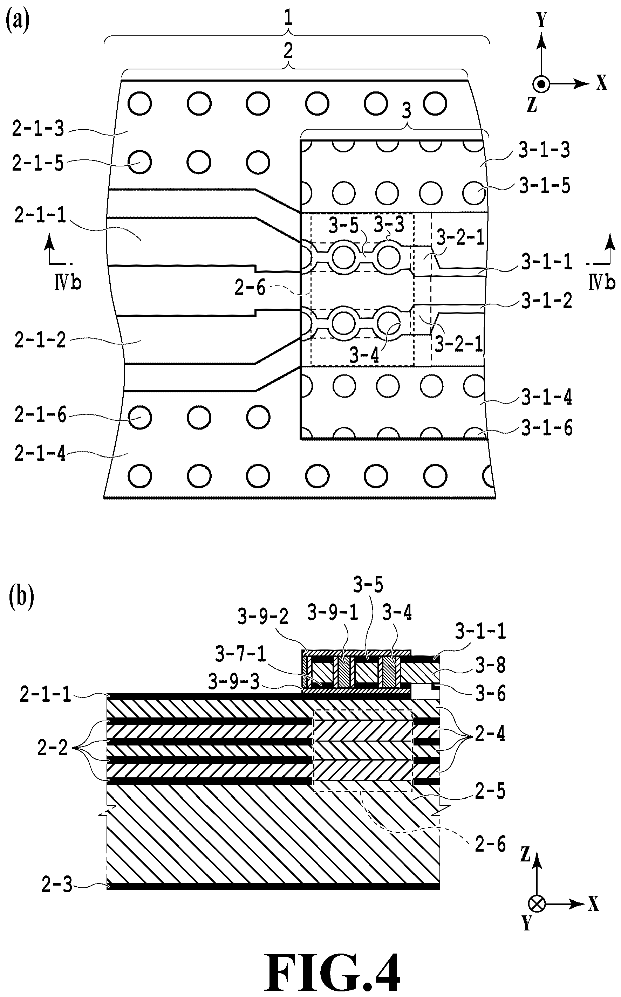

[Figure 4] Figure 4(a) is a top view of a radio frequency connection line (1) in a first embodiment of the present disclosure and Figure 4(b) is a sectional view in an IVb-IVb line in Figure 4(a).

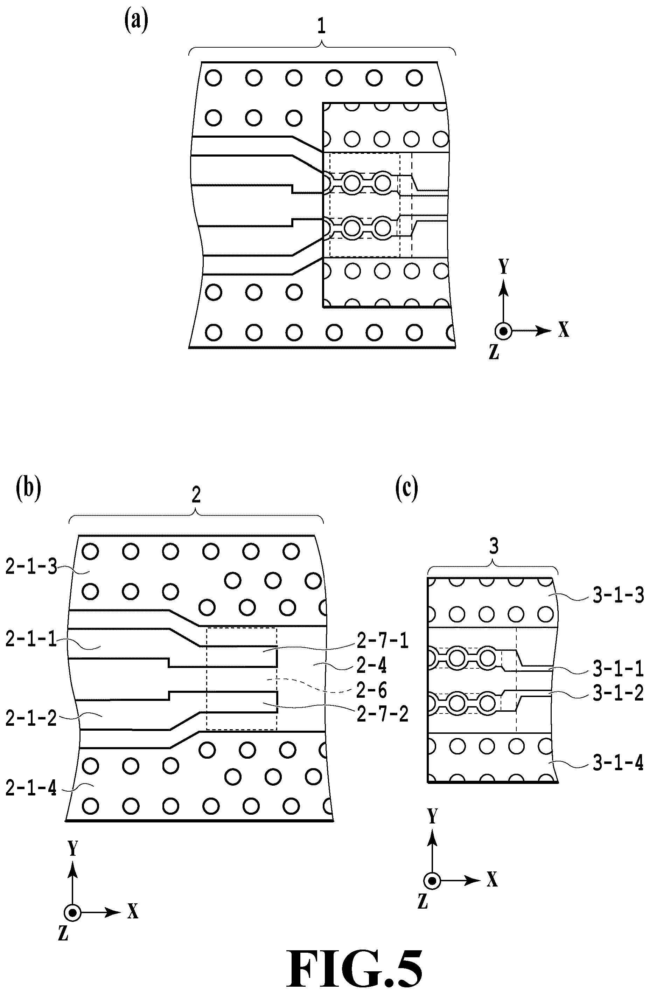

[Figure 5] Figure 5(a) is a top view of the radio frequency connection line (1) in the first embodiment corresponding to Figure 4(a), Figure 5(b) is a top view of an end portion of a first differential radio frequency line (2), and Figure 5(c) is a top view of an end portion of a second differential radio frequency line (3).

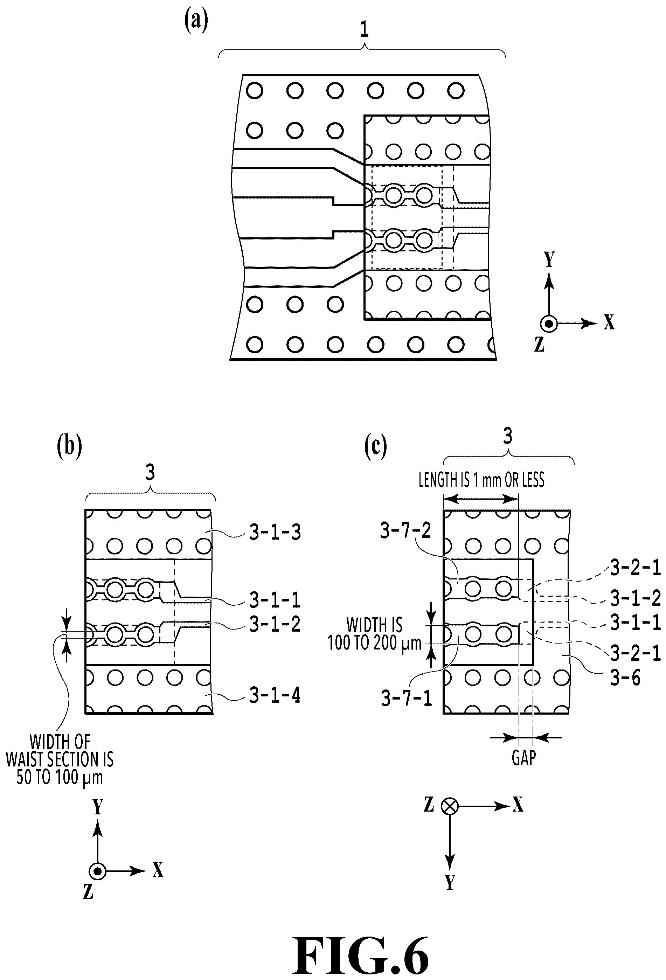

[Figure 6] Figure 6(a) is a top view of the radio frequency connection line (1) in the first embodiment corresponding to Figure 4(a), Figure 6(b) is a top view of the second differential radio frequency line (3) corresponding to Figure 5(c), and Figure 6(c) is a bottom view of the second differential radio frequency line (3).

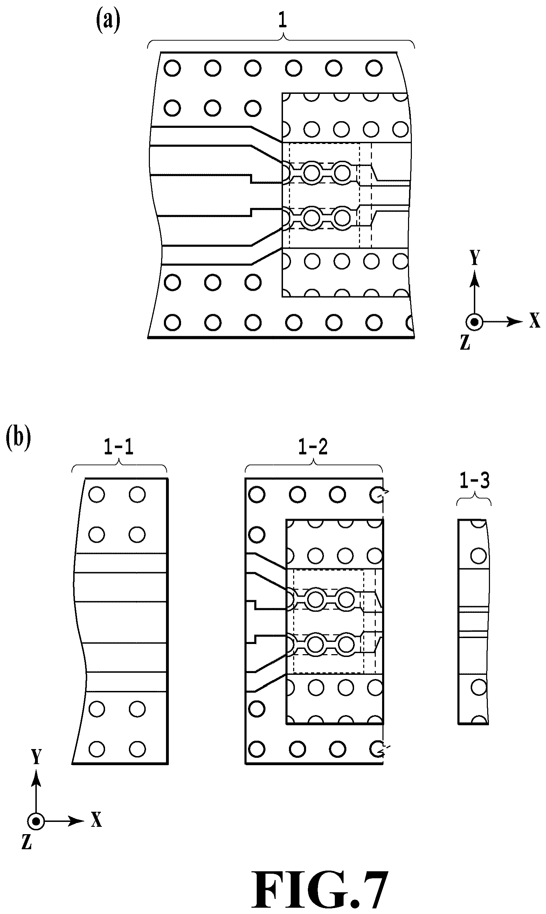

[Figure 7] Figure 7(a) is a top view of the radio frequency connection line (1) in the first embodiment corresponding to Figure 4(a) and Figure 7(b) is a diagram (1-1, 1-2, 1-3) obtained by dividing a region for each of functions of the radio frequency connection line (1).

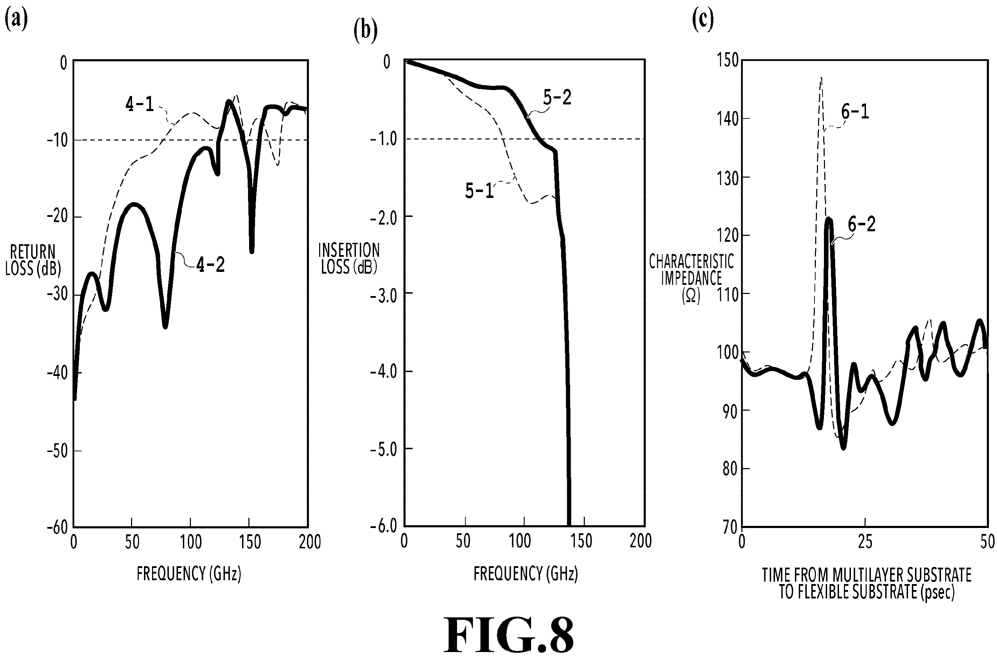

[Figure 8] Figure 8 is a diagram illustrating an S parameter and characteristic impedance of a radio frequency connection line in the first embodiment, Figure 8(a) is a graph trace of a return loss, Figure 8(b) is a graph trace of a insertion loss, and Figure 8(c) is a graph trace of characteristic impedance due to TDR.

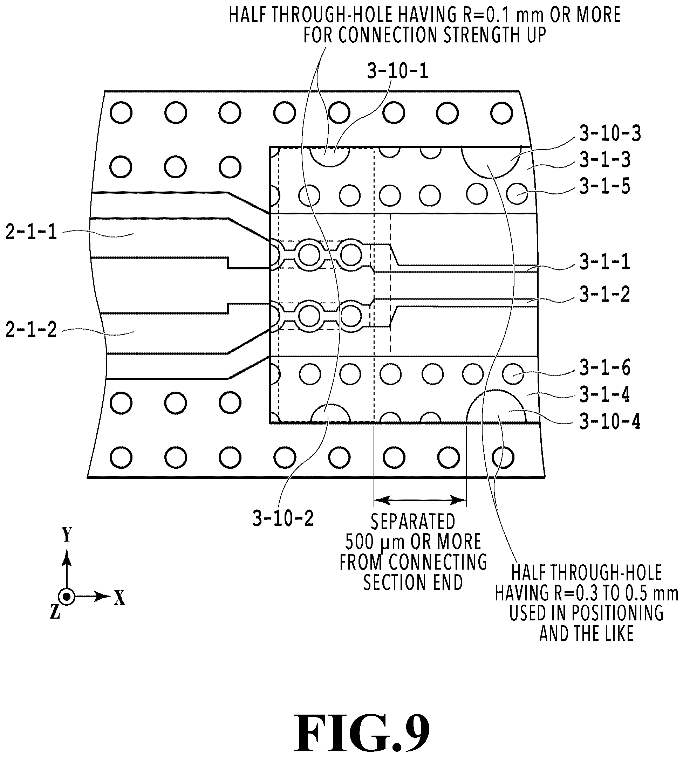

[Figure 9] Figure 9 is a diagram illustrating positions and shapes (3-10-1, 3-10-2, 3-10-3, 3-10-4) of half through-holes formed in a second substrate on which the second radio frequency line (3) in the first embodiment is formed.

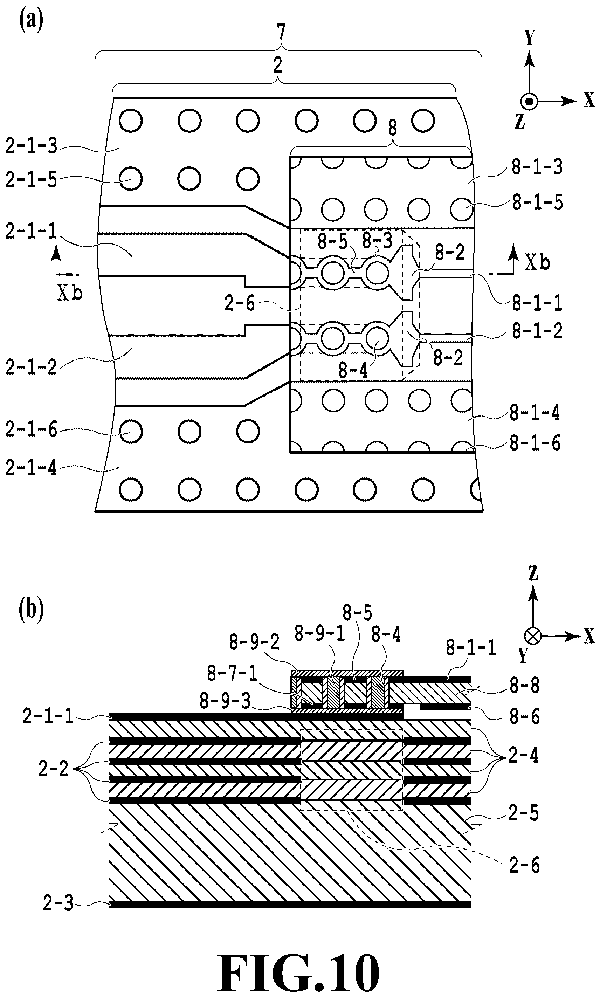

[Figure 10] Figure 10(a) is a top view of a radio frequency connection line (7) in a second embodiment of the present disclosure and Figure 10(b) is a sectional view in an IXb-IXb line in Figure 10(a).

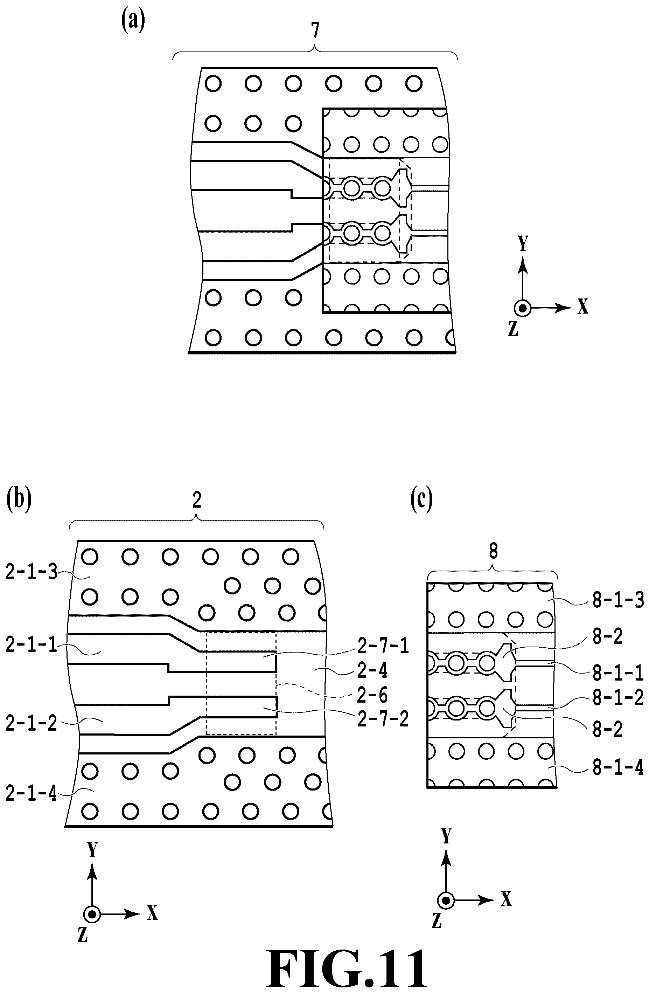

[Figure 11] Figure 11(a) is a top view of the radio frequency connection line (7) in the second embodiment corresponding to Figure 10(a), Figure 11(b) is a top view of an end portion of the first differential radio frequency line (2), and Figure 11(c) is a top view of an end portion of a second differential radio frequency line (8).

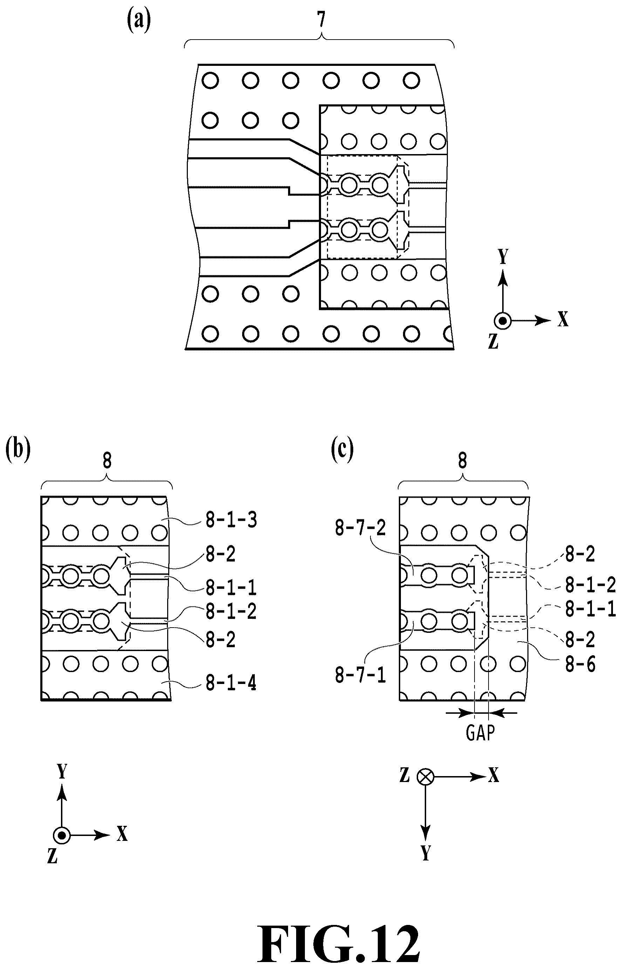

[Figure 12] Figure 12(a) is a top view of the radio frequency connection line (1) in the second embodiment corresponding to Figure 10(a), Figure 12(b) is a top view of the second differential radio frequency line (8) corresponding to Figure 11(c), and Figure 12(c) is a bottom view of the second differential radio frequency line (8).

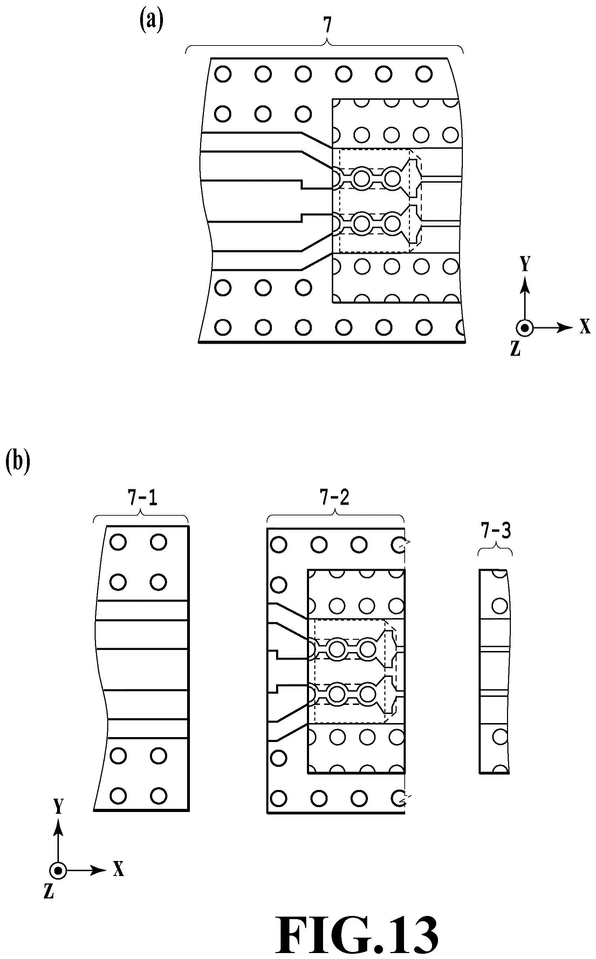

[Figure 13] Figure 13(a) is a top view of the radio frequency connection line (7) in the second embodiment corresponding to Figure 10(a) and Figure 13(b) is a diagram (7-1, 7-2, 7-3) obtained by dividing a region for each of functions of the radio frequency connection line (7).

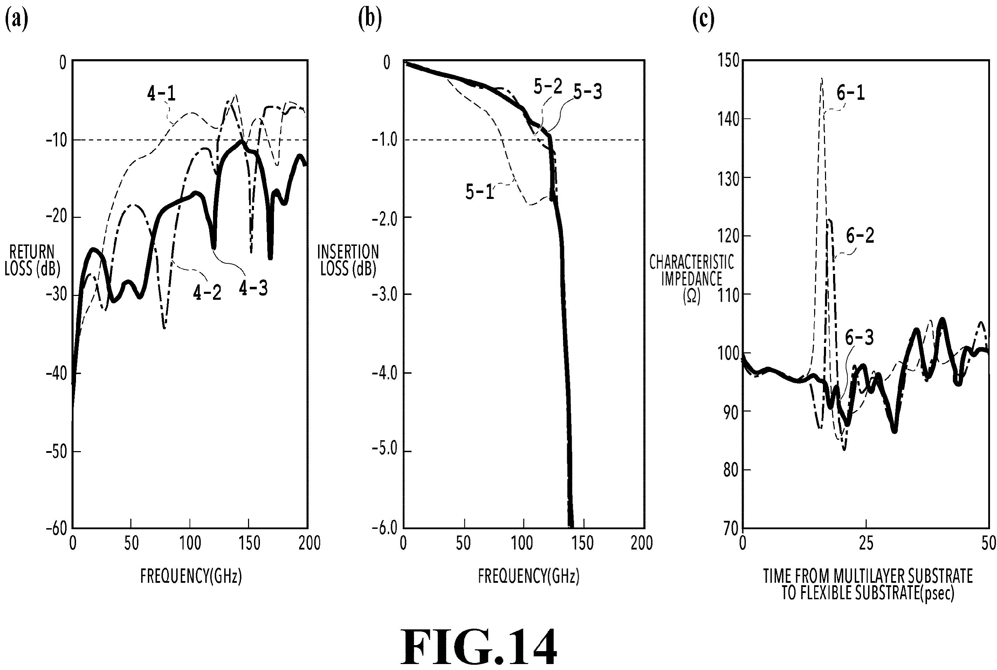

[Figure 14] Figure 14 is a diagram illustrating an S parameter and characteristic impedance of a radio frequency connection line in the second embodiment, Figure 14(a) is a graph trace of a return loss, Figure 14(b) is a graph trace of a insertion loss, and Figure 14(c) is a graph trace of characteristic impedance due to TDR.

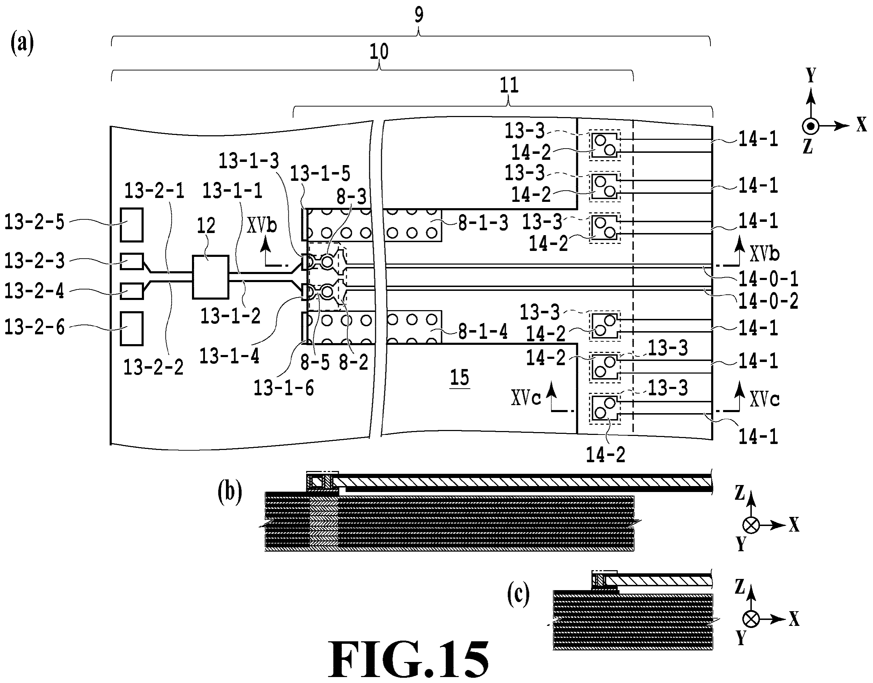

[Figure 15] Figure 15(a) is a top view of a radio frequency connection line (9) in a third embodiment of the present disclosure, Figure 15(b) is a sectional view in an XVb-XVb line in Figure 15(a), and Figure 15(c) is a sectional view in an XVc-XVc line in Figure 15(a).

### Description of Embodiments

A mode of implementation of the present disclosure is explained in detail below with reference to the drawings. The same or similar reference numerals and signs in the following explanation indicate the same or similar elements, and repeated explanation of the elements is sometimes omitted. Numerical values and materials in the following explanation are exemplifications. The present disclosure can be implemented using different numerical values and materials without departing from the gist.

In the mode of implementation, a material of a first substrate on which a first differential radio frequency line (2) is formed is polyimide (having a specific dielectric constant of 3.5) and a material of a second substrate on which a second differential radio frequency line (3) is formed is a low-loss resin material (having a specific dielectric constant of 3.46). However, not only this but it goes without saying that each of the material of the first substrate and the material of the second substrate may be quartz glass (having a specific dielectric constant of 3.8), a silicon nitride film (having a specific dielectric constant of 7), alumina ceramics (having a specific dielectric constant of 9.8), a compound semiconductor InP (having a specific dielectric constant of 12.4), or the like or may be other materials having insulation. Further, in the mode of implementation, a conductor film is a copper foil. However, not only this but it goes without saying that the conductor film can also be applied to an aluminum foil film, a gold foil film, a nickel thin film, or a palladium thin film or a composite layer metal thin film of one or a plurality of films among these films or the like. In embodiments explained below, it is described that one set of differential radio frequency lines (2, 3) are joined to form one differential radio frequency line (1). However, this can be extended to a form of joining a plurality of sets of differential radio frequency lines. This may be changed to a form of joining one set of single phase radio frequency lines as an alternative of the one set of differential radio frequency lines. Further, this can be extended to a form of joining a plurality of sets of single phase radio frequency lines.

Further, the number of conductor layers included in the first substrate on which the first differential radio frequency line (2) is formed is six. However, a total number of conductor layers is not limited to this and it goes without saying that the number of conductor layers less than six or larger than six can be applied. A plurality of penetrating through-holes (3-4) are formed at an end portion of a differential radio frequency line included in the second substrate on which the second differential radio frequency line is formed. However, it goes without saying that a conductor-embedded through-hole can also be applied.

### (First Embodiment)

A radio frequency connection line (1) in a first embodiment of the present disclosure is explained with reference to Figures. 4 to 9. The radio frequency connection line (1) is formed by joining an end portion of a first differential radio frequency line (2) formed on a first substrate and an end portion of a second differential radio frequency line (3) formed on a second substrate. When functionally divided, the radio frequency connection line (1) has a configuration in which a first radio frequency line (1-1) formed on the upper surface of the first substrate is disposed on the left side, a second radio frequency line (1-3) formed on the upper surface of the second substrate is disposed on the right side, and a radio frequency connection line (1-2) is disposed in the center (Figure 7(b)). This configuration is the same as the configuration of the functions of the radio frequency connection line of the related art illustrated in Figure 2(b).

The first differential radio frequency line (2) includes, on the upper surface of the first substrate, grounds (2-1-3, 2-1-4) including a set of a positive line (2-1-1) and a negative line (2-1-2) (also referred to as set of a positive signal line and a negative signal line or simply referred to as set of the lines) and including earthing ground potential on both sides of the set of the lines, includes an earthing ground layer (2-2) in a conductor layer immediately below the set of the lines, and further includes a bottom surface earthing ground layer (2-3) on the lowest surface of the first substrate. The first differential radio frequency line (2) includes ground VIAs (2-1-5, 2-1-6) in order to set the potential of all of the earthing ground layer (2-2) and the bottom surface earthing ground layer (2-3) to the earthing ground potential. Insulating layers (2-4, 2-5) are introduced among all the conductor layers. A part of a region of the grounds (2-1-3, 2-1-4) of the first differential radio frequency line (2) located in lower parts of earthing ground layers (3-1-3, 3-1-4) in the second differential radio frequency line (3) explained below configures a ground pad. The ground pad provides a joining region with a ground pad configured by a part of an earthing ground layer (3-6) in the second differential radio frequency line (3) on the lower surface of the second substrate.

On the other hand, the second differential radio frequency line (3) includes, on the upper surface of the second substrate, a set of a positive line (3-1-1) and a negative line (3-1-2) (also referred to as set of a positive signal line and a negative signal line or simply referred to as set of the lines) and a positive signal pad and a negative signal pad formed at an end portion of the set of lines. The positive signal pad and the negative signal pad include a circular pad (3-3), a through-hole (3-4) penetrating the center of the circular pad, and a waist line (3-5) connecting circular pads. The second differential radio frequency line (3) includes, on both sides of the positive line (3-1-1) and the negative line (3-1-2), grounds (3-1-3, 3-1-4) including earthing ground potential. Further, the second differential radio frequency line (3) includes, on the bottom surface of the second substrate, a positive pad (3-7-1), a negative pad (3-7-2), and an earthing ground layer (3-6) formed on the same surface as the positive pad and the negative pad in a form of surrounding the positive pad and the negative pad. A part of the earthing ground layer (3-6) in the second differential radio frequency line (3) located to face the ground pad configured by a part of the grounds (2-1-3, 2-1-4) in the first differential radio frequency line (2) explained above configures a ground pad. Further, a part present in an upper part of the ground pad configured by a part of the earthing ground layer (3-6) in the grounds (3-1-3, 3-1-4) also configures a ground pad. A part of the earthing ground layer (3-6) is connected to a part of the earthing ground layers (3-1-3, 3-1-4) by ground VIAs (3-1-5, 3-1-6). An insulating layer (3-8) is introduced between a conductor layer on the upper surface side and a conductor layer on the lower surface side.

The width of the waist line (3-5) configuring the second differential radio frequency line (3) is sufficiently smaller than the width of the positive pad (3-7-1) and the negative pad (3-7-2) provided on the bottom surface side. For example, considering rapidity of signal speed of a propagating radio frequency signal, it is important that a pad width (a portion represented by a broken line rectangle) excluding a land section forming a VIA provided on the bottom side suppresses development of electric capacitance in a connecting section as much as possible. Premised on adaptation to 200 GBd, at least the width (the length in a Y-axis direction) is desirably 200 µm or less and the length (the length in an X-axis direction) is desirably set to 1 mm or less (Figure 6(c)). Since the line width on the bottom surface side of the second substrate limits connection strength, it is inappropriate to set the line width to 100 µm or less. On the other hand, since the width (the length in the Y-axis direction) of a waist line portion on the upper surface side hardly affects the connection strength, the width is desirably as small as possible because the width affects capacitance but is desirably set to, for example, approximately 50 to 100 µm considering a disconnection risk and the like (Figure 6(b)).

Note that, when the through-hole (3-4) electrically connecting the upper surface side and the lower surface side of the second substrate is formed in an embedded VIA shape, the waist line is not always essential (for example, may be a linear line) and only a land of a VIA can also be formed. By forming the through-hole in the embedded VIA shape, occurrence of wetting-up to a pattern upper surface and wetting-spread of solder or the like used for connection is theoretically impossible. Therefore, it is possible to suppress development of electric capacitance and, as a result, suppress a reduction in impedance.

The size of the connecting section in the entire substrate is extremely small. Therefore, it goes without saying that alignment accuracy of a pattern on the first substrate and a pattern on the second substrate is important. Thus, in the present embodiment, as illustrated in Figure 9, half through-holes (3-10-3, 3-10-4) in which positioning pins can be used are provided on both sides (in a direction perpendicular to a signal propagating direction) of the second substrate. Considering a diameter size capable of guaranteeing sufficient strength and accuracy of the positioning pins and influence on patterns of the positive line (3-1-1) and the negative line (3-1-2) on the second substrate such as a flexible substrate by the half through-holes, it is suitable to set a curvature radius of the half through-holes to approximately 0.3 mm to 0.5 mm. This is because, for example, if the size of the half through-holes (3-10-3, 3-10-4) is excessively large, it is necessary to shave the grounds (3-1-3, 3-1-4) and the earthing ground layer (3-6) of the second substrate and, further, it is difficult to draw around the patterns of the positive line (3-1-1) and the negative line (3-1-2). Alignment can be accurately performed by providing the positioning pins on the first substrate. For example, the half through-holes (3-10-3, 3-10-4) can also be applied to a use of mechanically picking up and positioning the second substrate with a device or the like. Higher versatility can be simultaneously obtained. However, when considering connection by solder, a conductive adhesive, or the like using a hot bar, deterioration in workability such as inability to drop a hot bar tool is caused if the positioning pins or the like are disposed in the same row as the connecting section. In that case, the positioning pins or the like need to be separated at least 500 µm or more in the signal propagating direction from the connecting section. Further, after the connection, connection strength can be increased by also connecting the half through-holes (3-10-3, 3-10-4) to the first substrate by the solder, the conductive adhesive, or the like. When the half through-holes (3-10-3, 3-10-4) are connected by solder, regions having a curvature radius + 100 µm or more on the side surfaces and the upper surfaces and the lower surfaces of the half through-holes (3-10-3, 3-10-4) need to be metalized. When the regions are metalized, it is desirable, from the viewpoint of influence on the second differential radio frequency line (3) of the second substrate and easiness of soldering, that metalizing of the regions on the upper surfaces and the lower surfaces of the half through-holes and metalizing of the grounds (3-1-3, 3-1-4) and the earthing ground layer (3-6) of the second substrate are separated as much as possible.

Similarly, from the viewpoint of the improvement of the connection strength, by disposing at least one or more half through-holes (3-10-1, 3-10-2) having a curvature radius of 0.1 mm or more (larger half through-holes are effective for the improvement of the connection strength) on an edge side of the second substrate (both sides of the second substrate explained above) parallel to the connecting section and connecting the half through-holes to the first substrate and fixing the half through-holes, the connecting strength can be improved.

The first differential radio frequency line (2) formed on the first substrate and the second differential radio frequency line (3) formed on the second substrate are electrically permanently connected. In the present embodiment, solder is used. A positive pad (2-7-1) formed at an end portion of the positive line (2-1-1) and a negative pad (2-7-2) formed at an end portion of the negative line (2-1-2) of the first differential radio frequency line (2) formed on the first substrate and a positive pad (3-7-1) formed at an end portion of the positive line (3-1-1) and a negative pad (3-7-2) formed at an end portion of the negative line (3-1-2) of the second differential radio frequency line (3) formed on the second substrate are connected by a bottom surface solder layer (3-9-3) (Figure 4(b)). Note that, at the time of heating to the solder at the time of connection, since fluidity of the solder appears, the solder wet-spreads to the inside of the through-hole (3-4) formed on the second substrate and to the upper surface of an end portion of a line of the second differential radio frequency line (3) formed on the second substrate. In-through-hole solder (3-9-1) and upper surface solder (3-9-2) are respectively finished in a formed state (Figure 4(b)).

In the present embodiment, the region (2-6) in which the conductive layer is selectively removed is provided in the earthing ground layer (2-2) that is the conductive layer in the first substrate immediately below the region joined by the solder. This is a basic structure introduced in order to prevent, when an end portion of the first differential radio frequency line (2) formed on the first substrate and an end portion of the second differential radio frequency line (3) formed on the second substrate are joined by solder, a size of a conductor in a joining region from becoming larger than the size before the joining to thereby increase capacitance and reduce impedance.

On the other hand, at end portions of the positive line (3-1-1) and the negative line (3-1-2) of the second differential radio frequency line (3) formed on the second substrate, conductor layers (the positive pad (3-7-1) and the negative pad (3-7-2)) on the bottom surface side are electrically joined by a penetrating through-hole. The second differential radio frequency line (3) includes the earthing ground layer (3-6) in the conductor layer on the bottom surface side. As explained above, in order to prevent short-circuit of the earthing ground layer (3-6) and the positive pad (3-7-1) and the negative pad (3-7-2), the earthing ground layer (3-6) is formed at a plate end to surround the positive pad (3-7-1) and the negative pad (3-7-2). In this way, as in the related art illustrated in Figure 1, a predetermined gap is formed between the earthing ground layer (3-6) and the positive pad (3-7-1) and the negative pad (3-7-2) (Figure 6(c)). At this time, when extending to the plate end in the extending direction (the X-axis direction), the positive line (3-1-1) and the negative line (3-1-2) configuring the second differential radio frequency line (3) formed on the second substrate lose capacitance with the earthing ground layer (3-6) in a region of the gap and, since characteristic impedance markedly rises, change to high impedance lines. Accordingly, a radio frequency signal suffers a large return loss and deterioration in a band characteristic occurs. In the present embodiment, the gap is set to 100 µm or less sufficiently smaller than a quarter length of a guide wavelength equivalent to 100 GHz in the second substrate and, further, when the positive line (3-1-1) and the negative line (3-1-2) configuring the second differential radio frequency line (3) formed on the second substrate extend to the plate end, the positive line (3-1-1) and the negative line (3-1-2) are formed in a shape (3-2-1) having a line width larger than the width of the positive line (3-1-1) and the negative line (3-1-2) to electrically give capacitance (Figure 6(c)). This makes it possible to offset development of inductivity that is the origin of a high impedance characteristic in the gap region of 100 µm or less explained above. In the present embodiment, the differential radio frequency line is treated as one example. However, capacitive joining between the positive line and the negative line occurs in a differential signal in the differential radio frequency line and an electric line of force occurs between the lines. For the purpose of maintaining a distribution shape of the electric line of force between the lines, making it possible to maintain a joining mode of an electromagnetic field, and reducing reflection due to an electromagnetic field mode change, the present embodiment has a characteristic that the gap between the positive line (3-1-1) and the negative line (3-1-2) is the same even in a line (3-2-1) having the shape with the increased line width explained above.

Figure 8 illustrates an S parameter and characteristic impedance of the radio frequency connection line in the first embodiment together with the characteristics of the radio frequency connection line of the related art. Figure 8(a) illustrates a simulation waveform of a graph trace of a return loss of the S parameter, Figure 8(b) illustrates a simulation waveform of a graph trace of a insertion loss of the S parameter, and Figure 8(c) illustrates a simulation waveform of a graph trace of the characteristic impedance due to TDR (time domain reflectometry). In Figure 8, broken line graph traces (4-1, 5-1, 6-1) are characteristics concerning the related art and solid line graph traces (4-2, 5-2, 6-2) are characteristics concerning the present embodiment. In creation of a simulation model, the simulation model is designed to match differential impedance of 100 Ω. It is clearly seen that a return loss and a insertion loss in a joining section of the first differential radio frequency line (2) and the second differential radio frequency line (3) are satisfactory in the present embodiment when target standard values are respectively set to -10 dB (10% of power is reflected) and 1 dB (0.2 times of power is lost). Actually, it is seen that, in the graph trace of the characteristic impedance due to the TDR as well, peaky characteristic impedance that occurs in the gap area explained above in the related art is improved.

### (Second Embodiment)

A radio frequency connection line (7) in a second embodiment of the present disclosure is explained with reference to Figures 10 to 13. The radio frequency connection line (7) is formed by joining an end portion of a first differential radio frequency line (2) formed on a first substrate and an end portion of a second differential radio frequency line (8) formed on a second substrate. When functionally divided, the radio frequency connection line (7) has a configuration in which a first radio frequency line (7-1) formed on the upper surface of the first substrate is disposed on the left side, a second radio frequency line (7-3) formed on the upper surface of the second substrate is disposed on the right side, and a radio frequency connection line (7-2) is disposed in the center (Figure 13(b)). This configuration is the same as the configuration of the functions of the radio frequency connection line of the related art illustrated in Figure 2(b).

The first differential radio frequency line (2) formed on the first substrate includes, on the upper surface of the first substrate, grounds (2-1-3, 2-1-4) including a set of a positive line (2-1-1) and a negative line (2-1-2) (that is a set of the lines) and including earthing ground potential on both sides of the set of the lines, includes an earthing ground layer (2-2) in a conductor layer immediately below the set of the lines, and further includes a bottom surface earthing ground layer (2-3) on the lowest surface of the first substrate. The first differential radio frequency line (2) includes ground VIAs (2-1-5, 2-1-6) in order to set the potential of all of the earthing ground layer (2-2) and the bottom surface earthing ground layer (2-3) to the earthing ground potential. Insulating layers (2-4, 2-5) are introduced among all the conductor layers.

On the other hand, the second differential radio frequency line (8) includes, on the upper surface of the second substrate, a set of a positive line (8-1-1) and a negative line (8-1-2) (also referred to as set of a positive signal line and a negative signal line or simply referred to as set of the lines) and a positive signal pad and a negative signal pad formed at an end portion of the set of lines. The positive signal pad and the negative signal pad include a circular pad (8-3) formed at the end portion of the set of the lines, a through-hole (8-4) penetrating the center of the circular pad (8-3), and a waist line (8-5) connecting circular pads. The second differential radio frequency line (8) includes, on both sides of the positive line (8-1-1) and the negative line (8-1-2), grounds (8-1-3, 8-1-4) including earthing ground potential. Further, the second differential radio frequency line (8) includes, on the bottom surface of the second substrate, a positive pad (8-7-1), a negative pad (8-7-2), and an earthing ground layer (8-6) formed on the same surface as the positive pad and the negative pad in a form of surrounding the positive pad and the negative pad. A part of the earthing ground layer (8-6) in the second differential radio frequency line (8) located to face the ground pad configured by a part of the grounds (2-1-3, 2-1-4) in the first differential radio frequency line (2) explained above configures a ground pad. Further, a part present in an upper part of the ground pad configured by a part of the earthing ground layer (8-6) in the grounds (8-1-3, 8-1-4) also configures a ground pad. The earthing ground layer (8-6) is connected to the earthing ground layers (8-1-3, 8-1-4) by ground VIAs (8-1-5, 8-1-6). An insulating layer (8-8) is introduced between a conductor layer on the upper surface side and a conductor layer on the lower surface side. The width of the waist line (8-5) explained above is sufficiently smaller than the width of the positive pad (8-7-1) and the negative pad (8-7-2) provided on the bottom surface side.

The first differential radio frequency line (2) formed on the first substrate and the second differential radio frequency line (8) formed on the second substrate are electrically permanently connected. In the present embodiment, solder is used. A positive pad (2-7-1) formed at an end portion of the positive line (8-1-1) and a negative pad (2-7-2) formed at an end portion of the negative line (2-1-2) of the first differential radio frequency line (2) formed on the first substrate and a positive pad (8-7-1) formed at an end portion of the positive line (8-1-1) and a negative pad (8-7-2) formed at an end portion of the negative line (8-1-2) of the second differential radio frequency line (8) formed on the second substrate are connected by a bottom surface solder layer (8-9-3) (Figure 10(b)). Note that, at the time of heating to the solder at the time of connection, since fluidity of the solder appears, the solder wet-spreads to the inside of the through-hole (8-4) formed on the second substrate and to the upper surface of an end portion of a line of the second differential radio frequency line (8) formed on the second substrate. In-through-hole solder (8-9-1) and upper surface solder (8-9-2) are respectively finished in a formed state (Figure 10(b)).

In the present embodiment, the region (2-6) in which the conductive layer is selectively removed is provided in the earthing ground layer (2-2) that is the conductive layer on the first substrate immediately below the region joined by the solder. This is a basic structure introduced in order to prevent, when an end portion of the first differential radio frequency line (2) formed on the first substrate and an end portion of the second differential radio frequency line (8) formed on the second substrate are joined by solder, a size of a conductor in a joining region from becoming larger than the size before the joining to thereby increase capacitance.

On the other hand, at end portions of the positive line (8-1-1) and the negative line (8-1-2) of the second radio frequency line (3) formed on the second substrate, conductor layers (the positive pad (8-7-1) and the negative pad (8-7-2)) on the bottom surface side and the upper surface side are electrically joined by a penetrating through-hole. The second differential radio frequency line (8) includes the earthing ground layer (8-6) in the conductor layer on the bottom surface side. As explained above, in order to prevent short-circuit of the earthing ground layer (8-6) and the positive pad (8-7-1) and the negative pad (8-7-2), the earthing ground layer (8-6) is formed at a plate end to surround the positive pad (8-7-1) and the negative pad (8-7-2). In this way, a predetermined gap is formed between the earthing ground layer (8-6) and the positive pad (8-7-1) and the negative pad (8-7-2) (Figure 12(c)). At this time, when extending to the plate end in the extending direction (the X-axis direction), the positive line (8-1-1) and the negative line (8-1-2) configuring the second differential radio frequency line (8) formed on the second substrate lose capacitance with the earthing ground in a region of the gap and, since characteristic impedance markedly rises, change to high impedance lines. Accordingly, a radio frequency signal suffers a large return loss and deterioration in a band characteristic occurs. In the present embodiment, the gap is set to 100 µm or less and, further, when the positive line (8-1-1) and the negative line (8-1-2) configuring the second differential radio frequency line (8) formed on the second substrate extend to the plate end in the extending direction (the X-axis direction), the second differential radio frequency line (8) has a line shape (8-2) having a line width larger than the width of the positive line (8-1-1) and the negative line (8-1-2) and, further, larger (wider) than a value of a diameter of the circular pad (8-3) provided on the second substrate. In the present embodiment, since the second differential radio frequency line (8) is a differential line, there is a characteristic that improvement of capacitance between the positive line (8-1-1) and the negative line (8-1-2) is also further obtained by the line shape (8-2) explained above. Note that the line shape (8-2) explained above is a shape including a plurality of vertexes but is not limited to this. The external shape of the second differential radio frequency line (8) may be a curved shape. Since the second differential radio frequency line (8) has the line shape (8-2) in the present embodiment, inductivity that is the origin of a high impedance characteristic in the gap region of 100 µm or less explained above can be further cancelled.

The shape of the portion surrounding the positive pad (8-7-1) and the negative pad (8-7-2) is, in the first embodiment, the rectangle having the two sides parallel to the longitudinal direction of the second radio frequency line and the two sides perpendicular to the longitudinal direction of the second radio frequency line. In the present embodiment, the shape is a hexagon. The hexagon has two sides parallel to the longitudinal direction of the second radio frequency line, two sides perpendicular to the longitudinal direction of the second radio frequency line, and two sides connecting, of the two sides perpendicular to the longitudinal direction of the second radio frequency line, a side on the side of the positive line (8-1-1) and the negative line (8-1-2) and the two sides parallel to the longitudinal direction of the second radio frequency line. An inner angle on the side of the positive line (8-1-1) and the negative line (8-1-2) of the hexagon is an obtuse angle. The shape of the portion surrounding the positive pad (8-7-1) and the negative pad (8-7-2) may be a shape in which the two sides connecting, of the two sides perpendicular to the longitudinal direction of the second radio frequency line of the hexagon in the present embodiment, the side on the side of the positive line (8-1-1) and the negative line (8-1-2) and the two sides parallel to the longitudinal direction of the second radio frequency line are curved lines.

Figure 14 illustrates an S parameter and characteristic impedance of the radio frequency connection line in the second embodiment together with the characteristics of the radio frequency connection line of the related art and the characteristics of the radio frequency connection line in the first embodiment. Figure 14(a) illustrates a simulation waveform of a graph trace of a return loss of the S parameter, Figure 14(b) illustrates a simulation waveform of a graph trace of a insertion loss of the S parameter, and Figure 14(c) illustrates a simulation waveform of a graph trace of the characteristic impedance due to TDR (time domain reflectometry). In Figure 14, broken line graph traces (4-1, 5-1, 6-1) are characteristics concerning the related art, alternate long and short dash line graph traces (4-2, 5-2, 6-2) are characteristics concerning the first embodiment, and solid line graph traces (4-3, 5-3, 6-3) are characteristics concerning the present embodiment. In simulation, the characteristic impedance is designed to match a differential impedance of 100 Ω. It is seen that a return loss and a insertion loss in a joining section of the first radio frequency line (2) and the second radio frequency line (8) in the radio frequency connection line (7) in the present embodiment is further improved in a characteristic of the return loss in the present embodiment than in the first embodiment when target standard values are respectively set to -10 dB (10% of power is reflected) and 1 dB (0.2 times of power is lost). Actually, it is seen that, in the graph trace of the characteristic impedance due to the TDR as well, peaky characteristic impedance that occurs in the gap area explained above in the rigid substrate in the related art is further improved.

### (Third Embodiment)

A radio frequency connection line (9) in a third embodiment of the present disclosure is explained with reference to Figure 15. The radio frequency connection line (9) is formed by joining end portions of first differential radio frequency lines (13-1-1, 13-1-2, 13-2-1, 13-2-2) formed on a first substrate and end portions of second differential radio frequency lines (14-0-1, 14-0-2) formed on a second substrate. The first differential radio frequency lines (13-1-1, 13-1-2, 13-2-1, 13-2-2) are formed in a first differential radio frequency circuit (10) on the first substrate (for example, an IC or LSI substrate). The second differential radio frequency lines (14-0-1, 14-0-2) are formed on a line substrate (11) serving as the second substrate.

The differential radio frequency circuit (10) formed on the first substrate includes a plurality of DC power supply pads and a DC earthing ground pad (13-3) at a plate end on the right side of an insulating layer (15) on the upper surface side of the first substrate and includes differential signal pads (13-2-3 and 13-2-4) and radio frequency earthing ground pads (13-2-5 and 13-2-6) at a plate end on the left side.

The differential radio frequency circuit (10) includes, on the insulating layer (15) on the upper surface side of the first substrate, a differential gain circuit (12) and the first differential radio frequency lines (13-1-1, 13-1-2, 13-2-1, 13-2-2) for radio frequency signal input and output electrically connected to the differential gain circuit (12). A positive pad (13-1-3) and a negative pad (13-1-4) are formed at an end portion of the first differential radio frequency line.

The line substrate (11) serving as the second substrate includes a second differential signal pad, the second differential radio frequency lines (14-0-1, 14-0-2), and a plurality of pads (14-2) including penetrating through-holes. The plurality of pads (14-2) are electrically connected to a DC power supply line and a DC earthing ground line (14-1). The second differential signal pad has the same configuration as the configuration in the second embodiment and includes, at end portions of the second differential radio frequency lines (14-0-1, 14-0-2), on the upper surface side of the second substrate, a circular pad (8-3), a waist line (8-5) connecting circular pads, and a line shape (8-2) having width larger (wider) than a value of a diameter of the circular pad (8-3). The circular pad (8-3) is connected to, via a penetrating through-hole (not illustrated) and a pad on the lower surface side (not illustrated), the positive pad (13-1-3) and the negative pad (13-1-4) formed at an end portion of the first differential radio frequency line. Earthing ground layers (8-1-3, 8-1-4) are provided on both sides of the second differential signal pad. The earthing ground layers (8-1-3, 8-1-4) are connected to earthing grounds (13-1-5, 13-1-6) of the first substrate via a penetrating through-hole (not illustrated) and a pad on the lower surface side (not illustrated).

In general, a conductor cross section shape size of a radio frequency line provided on an IC or LSI substrate is only several micron angle. It is known that an insulating layer is also formed at thickness of several microns. In the radio frequency line having such a dimensional shape, a propagation loss is larger as a frequency of a radio frequency signal is higher. In the case of a 200 GBd use, in particular, the length of a propagation line is limited. In the present embodiment, the radio frequency connection line (9) has a structure in which, on the IC or LSI substrate, a radio frequency signal pad and a radio frequency earthing ground pad that handle such a radio frequency are provided on the substrate inner side without being provided at a plate end position separated from the radio frequency gain circuit (12) and are connected to the second differential radio frequency line on the line substrate (11) serving as the second substrate having a lower propagation loss. Accordingly, it is possible to relatively easily implement an IC or an LSI for the 200 GBd use without deteriorating a signal level of a radio frequency signal.

### Industrial Applicability

There is provided a radio frequency connection line in which characteristic impedance is matched when end portions of radio frequency lines formed on separate substrates are connected at the respective substrate end portions in a form in which the end portions are set in contact with each other.

### Reference Signs List

1 Radio frequency connection line
2 Differential radio frequency line
2-1-1 Positive line (Conductor layer)
2-1-2 Negative line (Conductor layer)
2-1-3, 2-1-4 Ground (Conductor layer)
2-1-5, 2-1-6 Ground VIA
2-2 Earthing ground layer (Conductor layer)
2-3 Bottom surface earthing ground layer (Conductor layer)
2-4, 2-5 Insulating layer
2-6 Region where the conductor layer is removed
2-7-1 Positive pad
2-7-2 Negative pad
3 Differential radio frequency line
3-1-1 Positive line (Conductor layer)
3-1-2 Negative line (Conductor layer)
3-1-3, 3-1-4 Earthing ground (Conductor layer)
3-1-5, 3-1-6 Ground VIA
3-2-1 Wide shape
3-3 Circular pad
3-4 Through-hole
3-5 Waist line
3-6 Earthing ground layer (Conductor layer)
3-7-1 Positive pad
3-7-2 Negative pad
3-8 Insulating layer
3-9-1 In-through-hole solder
3-9-2 Upper surface solder
3-9-3 Bottom surface solder layer
3-10-1, 3-10-2, 3-10-3, 3-10-4 Half through-hole
7 Radio frequency connection line
8 Differential radio frequency line
8-1-1 Positive line
8-1-2 Negative line
8-1-3, 8-1-4 Earthing ground (Conductor layer)
8-1-5, 8-1-6 Ground VIA
8-2 Wide line shape
8-3 Circular pad
8-4 Through-hole
8-5 Waist line
8-6 Earthing ground layer (Conductor layer)
8-7-1 Positive pad
8-7-2 Negative pad
8-8 Insulating layer
8-9-1 In-through-hole solder
8-9-2 Upper surface solder
8-9-3 Bottom surface solder layer
9 Radio frequency connection line
10 Differential radio frequency circuit
11 Line substrate
14-2 Pad
13-1-1, 13-1-2 Differential radio frequency line
13-1-3 Positive pad
13-1-4 Negative pad
13-1-5, 13-1-6 Ground (Conductor layer)
13-2-1, 13-2-2 Differential radio frequency line
13-2-3, 13-2-4 Differential signal pad
13-2-5, 13-2-6 Radio frequency earthing ground pad
13-3 DC power supply pad, DC earthing ground pad
14-0-1, 14-0-2 Differential radio frequency line
14-1 DC power supply line, DC earthing ground line
14-2 Pad
15 Insulating layer
100 Rigid substrate
101 Signal line
102 Signal line pitch conversion section
111 First wiring layer
112 Second wiring layer
113 Third wiring layer
114 First insulating layer
115 Second insulating layer
126 Ground opening
200 Flexible substrate
201 Signal line
202 Signal VIA
203 Signal line taper section
204 Ground VIA
210 Ground layer
211 Ground pad
212 Signal pad
213 Ground layer taper section
221 First wiring layer
222 Second wiring layer
223 First insulating layer
300 Solder

## Claims

1. A radio frequency connection line in which a first radio frequency line formed on a first substrate having insulation and a second radio frequency line formed on a second substrate having insulation different from the first substrate are electrically connected, wherein
the first radio frequency line includes:
a first main line having conductivity formed on an upper surface of the first substrate, the first main line including a first signal line;
a first signal pad electrically connected to an end portion of the first signal line formed on the upper surface of the first substrate; and
a first ground pad formed on the upper surface of the first substrate,
the second radio frequency line includes:
a second main line having conductivity formed on an upper surface of the second substrate, the second main line including:
a second signal line; and
a second earthing ground formed on the upper surface of the second substrate;
a second signal pad electrically connected to an end portion of the second signal line formed on the upper surface of the second substrate;
a second ground pad electrically connected to an end portion of the second earthing ground formed on the upper surface of the second substrate;
a third signal pad formed at a position immediately below the second signal pad on a lower surface of the second substrate; and
an earthing ground layer formed on the lower surface of the second substrate in a form of surrounding the third signal pad, the earthing ground layer including a third ground pad formed at a position immediately below the second ground pad on the lower surface of the second substrate,
the first signal pad and the third signal pad are joined to face each other,
the first ground pad and the third ground pad are joined to face each other,
a gap between the third signal pad and the earthing ground layer in a longitudinal direction of the second radio frequency line is smaller than a quarter of a guide wavelength, and
width of the second signal pad in a direction perpendicular to the longitudinal direction of the second radio frequency line is larger than width of the second signal line in the direction perpendicular to the longitudinal direction of the second radio frequency line, and an interval between the second signal pad and the second ground pad is narrower than an interval between the second signal line and the second earthing ground.

2. The radio frequency connection line according to claim 1, wherein a shape of the earthing ground layer in the form surrounding the third signal pad is any one of
a rectangle including two sides parallel to the longitudinal direction of the second radio frequency line and two sides perpendicular to the longitudinal direction of the second radio frequency line,
a hexagon including the parallel two sides, the perpendicular two sides, and two sides connecting, of the perpendicular two sides, a side on the second signal line side and the parallel two sides, and
a shape including the parallel two sides, the perpendicular two sides, and two curved lines connecting, of the perpendicular two sides, the side on the second signal line side and the parallel two sides.

3. The radio frequency connection line according to claim 2, further comprising at least one signal VIA made of a conductor penetrating the second substrate, the signal VIA being for making the second signal pad and the third signal pad electrically conductive, wherein the signal VIA is a conductor embedded VIA.

4. The radio frequency connection line according to claim 1, further comprising at least one signal VIA made of a conductor penetrating the second substrate, the signal VIA being for making the second signal pad and the third signal pad electrically conductive, wherein
a line connecting regions connected to the signal VIA in the second signal pad has a line shape having width smaller than width of a line connecting regions connected to the signal VIA in the third signal pad.

5. The radio frequency connection line according to claim 4, wherein
the first radio frequency line includes a first earthing ground formed on the upper surface of the first substrate,
the first signal line is a differential signal line in which a first positive signal line and a first negative signal line on which a differential signal including a pair of a positive signal and a negative signal propagates are disposed adjacent to each other at a predetermined first interval, the first earthing ground being disposed on both sides of the first signal line,
the second signal line is a differential signal line in which a second positive signal line and a second negative signal line on which the differential signal including the pair of the positive signal and the negative signal propagates are disposed adjacent to each other at a predetermined second interval different from the first interval, the second earthing ground being disposed on both sides of the second signal line, and
the first positive signal line and the first negative signal line and the second positive signal line and the second negative signal line are respectively configured to be connected via the second signal pad, the signal VIA, and the third signal pad.

6. The radio frequency connection line according to claim 4, wherein
the first radio frequency line includes a first earthing ground formed on the upper surface of the first substrate,
the first signal line is a differential signal line in which a first positive signal line and a first negative signal line on which a differential signal including a pair of a positive signal and a negative signal propagates are disposed adjacent to each other at a predetermined first interval, the first earthing ground being disposed on both sides of the first signal line,
the second signal line is a differential signal line in which a second positive signal line and a second negative signal line on which the differential signal including the pair of the positive signal and the negative signal propagates are disposed adjacent to each other at a predetermined second interval different from the first interval, the second earthing ground being disposed on both sides of the second signal line,
the first positive signal line and the first negative signal line and the second positive signal line and the second negative signal line are respectively configured to be connected via the second signal pad, the signal VIA, and the third signal pad, and
a line of a connecting portion to the second positive signal line in the second signal pad has a line shape having width larger than width of the second signal pad, width of the third signal pad, and width of the second main line.

7. The radio frequency connection line according to claim 5 or 6, wherein
the first substrate includes:
a first lower surface earthing ground formed at a position immediately below the first signal line and the first earthing ground on a lower surface of the first substrate;
an earthing ground layer formed between an upper surface on which the first main line having conductivity is formed and the first lower surface earthing ground;
an insulating layer formed in an upper layer and a lower layer of the earthing ground layer; and
a ground VIA penetrating the first substrate, the ground VIA being for making the first lower surface earthing ground and the earthing ground layer electrically conductive, and
the earthing ground layer is not formed in a region immediately below the first signal pad.

8. The radio frequency connection line according to claim 5 or 6, wherein
width of the third signal pad is 100 to 200 µm, width of the second signal pad is 50 to 100 µm, and length in the longitudinal direction of the second radio frequency line of the third signal pad joined to correspond to the first signal pad is 1 mm or less, and
the radio frequency connection line further comprises:
a half through-hole having a curvature radius of 0.3 mm to 0.5 mm for positioning formed at a position separated 500 µm or more in the longitudinal direction of the second radio frequency line from the third signal pad; and
at least one half through-hole having a curvature radius of 0.1 mm or more for connection strength improvement formed at a position in a direction orthogonal to the longitudinal direction of the second radio frequency line of the third signal pad.
